Europäisches Patentamt

European Patent Office

Office européen des brevets

(19)

(11) Publication number: **0 081 226**
A2

(12) # EUROPEAN PATENT APPLICATION

(21) Application number: **82111276.0**

(22) Date of filing: **06.12.82**

(51) Int. Cl.³: **H 01 L 21/316**
**H 01 L 21/60, H 01 L 21/31**

(30) Priority: **08.12.81 JP 198116/81**

(43) Date of publication of application:
**15.06.83 Bulletin 83/24**

(84) Designated Contracting States:
**DE FR GB**

(71) Applicant: **Matsushita Electronics Corporation**
**1006, Oaza-Kadoma Kadoma-shi**
**Osaka 571(JP)**

(72) Inventor: **Mayumi, Shuichi**
**25, Nishinaka-machi Umekouji**
**Shimogyo-ku Kyoto City, 600(JP)**

(72) Inventor: **Asahi, Kunihiko**
**10-2, Kawazoe 1-chome**
**Takatsuki City, 569(JP)**

(72) Inventor: **Kamei, Ichizo**
**20-18, Nakayamatedori 4-chome**
**Chuo-ku Kobe City, 651(JP)**

(74) Representative: **Dr. Elisabeth Jung Dr. Jürgen**
**Schirdewahn Dr. Gerhard Schmitt-Nilson Dr. Gerhard B.**
**Hagen Dipl.-Ing. Peter Hirsch**
**Clemensstrasse 30 Postfach 40 14 68**
**D-8000 München 40(DE)**

(54) **Method of making semiconductor device.**

(57) A semiconductor device having phosphosilicate glass layer 6 is improved by adopting a new structure having a thin silicon nitride film 9 of a thickness lower than 3000 Å provided under such place that is to be covered by the phosphosilicate glass 6. The phosphosilicate glass 6 is subject to softening after necessary selective etching. Undesirable oxidation of silicon layer 4 at the part under the phosphosilicate glass film in a thermal treatment for the softening is suppressed. Accordingly, in a MOS IC, which uses polycrystalline silicon film 4 as gate electrode and as wiring conductors, the silicon nitride film 9 is formed to cover the polycrystalline silicon films 4, thereby undesirable oxidation of surface of the polycrystalline silicon film 4 is prevented, thereby shrink of pattern and/or forming of undesirable silicon oxide film around the gate electrode or wiring conductors are prevented.

FIG.2(f)

## Title of the Invention

Method of making semiconductor device

## Background of the Invention

1. Field of the Invention:

The present invention relates to method of making semiconductor device, especially that having step structure on the principal face of its substrate provided with high concentration phosphosilicate glass film in order to provide insulation film having smoothed face so as to assure forming of reliable metal film thereon.

2. Description of Prior Art:

It is known to use phosphosilicate glass (hereinafter is referred as PSG) film as insulation film to support aluminum or the like conduction film or electrode connecting wires in order to obtain smoothly curved face of the insulation film thereby to assure reliable wiring. However, a high temperature to soften the PSG for reflowing is likely to give undesirable influence, such as excessively deep diffusion of impurity of source or drain diffused regions, thereby making high integrated LSI with channel length of 2 µm or shorter hard to be realized. In order to make the diffusion depth shallower in such PSG type semiconductor device, use of a PSG of relatively low softening temperature has been proposed, but such PSG must have increased phosphorous concentration. And such high concentration of phosphorous induces a shortcoming of lowering reliability of the semiconductor device.

As a way to solve such problem, the inventors have found that reflowing being carried out in a high pressure water gas at a lower temperature of about 900°C is effective.

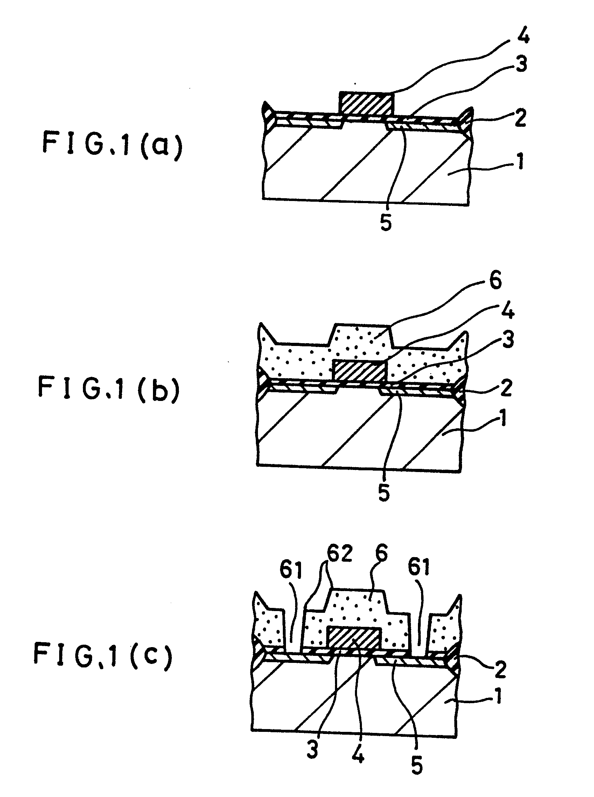

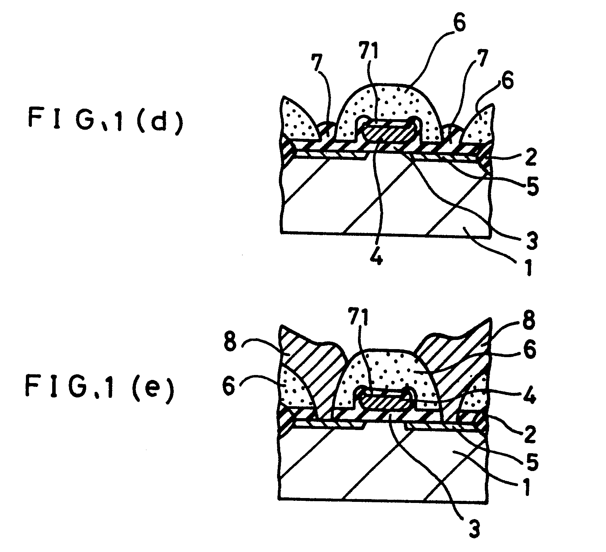

FIG. 1(a), FIG. 1(b), FIG. 1(c), FIG. 1(d) and

FIG. 1(e) show a manufacturing process of inventors' prior experiment which is not yet disclosed to the public.

As shown in FIG. 1(a) on

a silicon substrate ......................... 1,

the following layers are sequentially formed:

selectively formed oxide layer (LOCOS) ...... 2,

gate oxide film ...................:........ 3,

polycrystalline silicon gate region ........ 4 and

diffused regions ........................... 5.

Then, as shown in FIG. 1(b), PSG film 6 of for instance, phosphorous concentration of 8 mol % is formed on the substrate. Thereafter, in order to etch the PSG film, the substrate is heat treated in an oxidizing atmosphere at about 900°C for 30 minutes, followed by boring contact openings 61 in the PSG film 6. Then, in a high pressure furnace for instance, in a water gas atmosphere of 8 $kg/cm^2$,

heat treatment is carried out at 900°C for 10 minutes, thereby to reflow the PSG film as shown in FIG. 1(a).

In this reflowing step oxide films 77 are formed on exposed surface of silicon, and the silicon oxide films 77 is removed followed by forming of aluminum wiring film 8 on necessary part of the substrate to form MOS FET as shown in FIG. 1(e).

However, in the above-mentioned inventors' prior experiments the polycrystalline silicon region 4 is likely to be oxidized, thereby forming silicon oxide layer 71 and also making gate oxide film under the edge of gate region 4 thick, and such oxidation is prominent especially in high pressure water gas. Therefore, the problem is that the gate oxide film under the edge of gate electrode region 4 becomes too thick and pattern of the gate electrode region 4 becomes smaller than designed. And it has been necessary to remove the oxide silicon film by an etching step so as to expose the drain region and source region for electrode connection by aluminum film. In the inventors' prior experiment of FIG. 1, the problem of gate electrode regions being shrinked by oxidizing in the heat treatment for reflowing and resultant increase of resistance of polycrystalline silicon region remains.

In order to evade the above problem if the contact openings 61, 61 are bored prior to heat treatment for reflowing of the PSG in the high pressure water gas, edges 62, 62 at the shoulder part of the contact openings 61, 61 remains alike the conventional semiconductor devices

4

**0081226**

without enforcing PSG reflow.

<u>Summary of the Invention</u>

Therefore, the present invention is to provide a novel method of making semiconductor device using PSG for reliable wiring wherein undesirable oxidizing of silicon being suppressed during the heat treatment for reflowing of PSG film.

More particularly, the present invention is to provide a semiconductor device with PSG film for providing reliable wiring film wherein the method comprising the following steps:

forming a silicon nitride film on a semiconductor substrate,

forming a phosphosilicate glass film at least on selected part on the silicon nitride film,

boring contacting opening on selected parts of the phosphosilicate glass film retaining the silicon nitride film thereunder,

softening the phosphosilicate glass film to reflow it for smoothing edges thereof, and

removing by etching the silicon nitride film exposed from the openings and

forming at least a connection conductor film on the phosphosilicate glass film.

And semiconductor device in accordance with the present invention comprises:

a semiconductor substrate,

a silicon nitride film formed on selected parts of the semiconductor substrate,

a phosphosilicate glass film formed on selected parts of the semiconductor substrate to cover at least selected parts of the silicon nitride film and having reflow smoothed edges, and

at least a connection conductor film formed on the phosphorilicate glass film.

According to the method of making semiconductor device of the present invention, silicon substrate and polycrystalline silicon region are free from undesirable oxidizing during heat treatment for reflowing of PSG film, since it is masked and protected by the silicon nitride film.

Brief Explanation of the Drawing

FIG. 1(a), FIG. 1(b), FIG. 1(c), FIG. 1(d) and FIG. 1(e) are sectional elevation views illustrating the steps of manufacturing a semiconductor device in accordance with the inventors' prior experiment not being disclosed to the public.

FIG. 2(a), FIG. 2(b), FIG. 2(c), FIG. 2(d), FIG. 2(e) and FIG. 2(f) are sectional elevation views for illustrating manufacturing steps of an example embodying the present invention.

## Description of the Preferred Embodiments

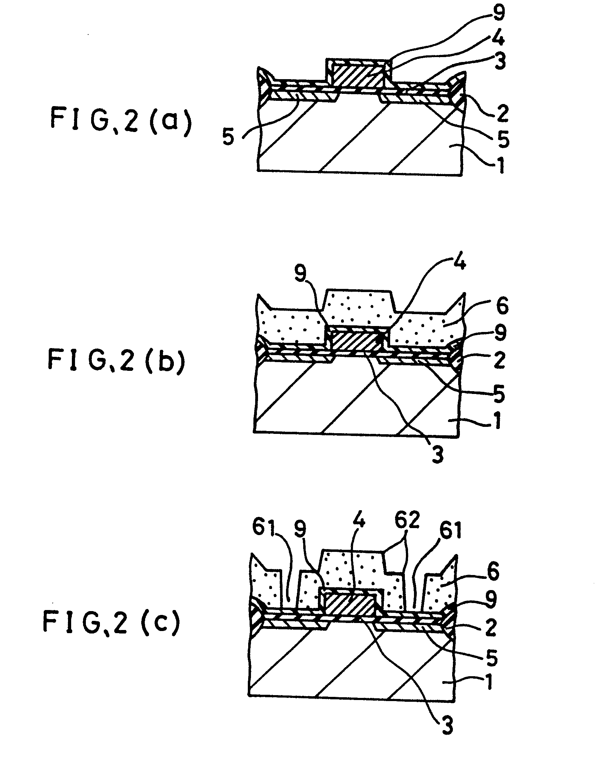

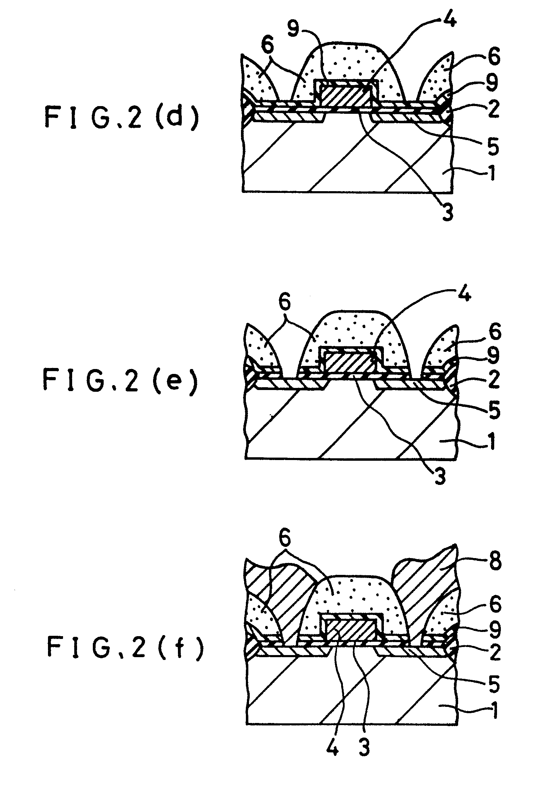

The method of manufacturing semiconductor device in accordance with the present invention is elucidated in detail in reference to FIG. 2(a), FIG. 2(b), FIG. 2(c), FIG. 2(d), FIG. 2(e) and FIG. 2(f) which show steps of manufature in sectional elevation views of one unit part of a MOS FET of a MOS IC.

First, selective oxide film (LOCOS i.e. local oxidation of silicon) 2 is formed on a principal face of a silicon substrate 1. And diffused regions 5, 5 for source region and drain regions are formed by known diffusion process and gate oxide film 3 is formed by known method, and thereon a polycrystalline silicon gate region 4 is formed by, for instance, chemical vapour deposition method. Then on all the face of the above-mentioned structured substrate, a silicon nitride film 9 of about 1000 Å thickness is formed by known method as shown in FIG. 2(a).

Then, phosphosilicate glass film 6 of about 8000 Å thickness containing about 8 mol % of phosphorous is formed on the silicon nitride film 9 as shown in FIG. 2(b). Subsequently, in order to harden the PSG film 6, the substrate is subject to a heat treatment for instance in oxygen gas of about 900°C for 30 minutes, followed by etching to bore contact openings 61 and 61 by using known photoresist film as mask as shown in FIG. 2(c).

Next, in a high pressure furnace, for instance, containing water gas of pressure of 8 kg/cm$^2$, at about 900°C, the above-mentioned substrate is subject to heat treatment for about 10 minutes in order to soften the PSG film to reflow as shown in FIG. 2(d). Thereafter, the silicon nitride film 9 exposed in the openings 61 is removed by plasma-etching for instance, in CF$_4$ gas. Subsequently, the silicon oxide film 3 exposed from the opening of the removed silicon nitride film 9 is removed by etching utilizing aqueous solution of hydrofluoric acid and ammonium fluoride as etchant, as shown in FIG. 2(e). And lastly, aluminum wiring film 8 is formed by known method, thereby completing a MOS FET as shown in FIG. 2(f).

When the method in accordance with the present invention is employed, surface of the silicon substrate 1 and the polycrystalline silicon region 4 are not oxidized because the silicon nitride film 9 covers the surface thereof.

In case there is no oxide silicon film 3 exists under the removed silicon nitride film 9, then there is no need to carry out the above-mentioned etching to remove the oxide silicon film 3.

As the etchant for the selective removal of the silicon oxide film, a mixed aqueous solution of hydroflouric acid and ammonium fluoride made as a mixture of 1 volume part of hydrofluoric acid of about 50% concentration and 6 to 20 volume parts of 40% ammonium fluoride, of 20°C is preferable. When a thin silicon oxide film is used, the volume parts of ammonium fluoride should be increased so as to slow down the etching speed for better controlling.

When the mixture contains 1 part of the 50% hydrofluoric acid and 6 parts of 40% ammonium fluoride, then the etching speed at 20°C is about 1000 Å/second. And the etching time should be 45 to 70 seconds. By such etching of the silicon oxide film, the silicon nitride film is retained substantially unetched.

For the silicon nitride film 9 as the mask, thickness should be between 300 Å to 3000 Å. When the thickness is much smaller than 300 Å, the silicon nitride film does not functions sufficiently as mask, since the $Si_3N_4$ film of 300 Å or less thickness will be oxidized during the heat treatment for the reflowing. When the thickness is much larger than 3000 Å, the $Si_3N_4$ film will be likely to make cracks due to the difference of thermal coefficient between $Si_3N_4$ film and silicon substrate.

According to the present invention, by use of forming the silicon nitride film as mask to cover the silicon substrate and polycrystalline silicon region, conventional problems induced by heat treatment for reflowing of the PSG film, such as inefficient reetching of silicon oxide film produced on the silicon substrate and undesirable thickening of gate oxide film due to oxidizing of polycrystalline gate region and resultant increase of polycrystalline silicon wiring conductors are all resolved.

Furthermore, it is also to be noticed that undesirable diffusion of phosphorous from PSG film to the source region and drain region which should be strictly prevented in case the MOS device is of p-channel type device, can be effectively avoided by means of masking by the silicon nitride film. This is particularly advantageous in case of making complementary MOS devices. Furthermore, the silicon nitride film can prevent diffusions of various ions such as water, etc., into transistor part.

Besides carrying out the reflowing heat treatment of PSG in the high pressure water gas, the reflowing can be made in normal pressure water gas or oxygen atmosphere by employing the method in accordance with the present invention.

The method of making the semiconductor device of the present invention is applicable not only to MOS IC but also to any other semiconductor devices wherein reflowing of PSG film is necessary.

As has been elucidated in detail referring to the preferred embodiment the present invention is very much advantageous manufacturing reliable semiconductor devices especially of high integrated semiconductor devices.

What is claimed is

1.      Method of making semiconductor device comprising the steps of:

    forming a silicon nitride film on a semiconductor substrate,

    forming a phosphosilicate glass film at least on selected part on said silicon nitride film,

    boring contacting opening on selected parts of said phosphosilicate glass film retaining said silicon nitride film thereunder,

    softening said phosphosilicate glass film to reflow it for smoothing edges thereof, and

    removing by etching said silicon nitride film exposed from said openings and

    forming at least a connection conductor film on said phosphosilicate glass film.

2.      Method of making semiconductor device in accordance with claim 1, wherein

    said silicon nitride film is formed to be thinner than 3000 $\overset{\circ}{A}$ and thicker than 300 $\overset{\circ}{A}$.

3.      Method of making semiconductor device in accordance with claim 1 or 2 which further comprising the steps of:

    prior to forming of said silicon nitride film, forming an electrode conductor of polycrystalline silicon film, and

said silicon nitride film covering said electrode conductor of polycrystalline silicon film.

4.      Method of making semiconductor device in accordance with claim 1 or 2, wherein phosphorous concentration in said phosphosilicate glass film is less than 8%.

5.      Method of making semiconductor device in accordance with claim 1 or 2, wherein said smoothing is made by heat treatment of said phosphosilicate glass film in a high pressure water gas of a temperature of 900°C or lower.

6.      Method of making semiconductor device in accordance with claim 1 or 2, wherein

        prior to forming of said silicon nitride film a silicon oxide film is formed at selected part under said silicon nitride film,

        and said silicon oxide film is etched by a mixed aqueous solution of hydrofluoric acid and ammonium fluoride.

7.      Method of making semiconductor device in accordance with claim 6, wherein

        said mixed aqueous solution is a mixture of 1 volume part of hydrofluoric acid of about 50% concentration and 6 to 20 volume parts of 40% ammonium fluoride.

8.      Method of making semiconductor device in accordance with claim 7, wherein

        said etching is made at 20°C for 45 to 70 seconds.

9.      A semiconductor device comprising:

a semiconductor substrate,

a silicon nitride film formed on selected parts of said semiconductor substrate,

a phosphosilicate glass film formed on selected parts of said semiconductor substrate to cover at least selected parts of said silicon nitride film and having reflow smoothed edges, and

at least a connection conductor film formed on said phosphosilicate glass film.

10.     A semiconductor device in accordance with claim 9, wherein

said silicon nitride film is thinner than 3000 Å and thicker than 300 Å.

11.     A semiconductor device in accordance with claim 9 or 10, wherein

said semiconductor substrate has an electrode conductor of polycrystalline film.

12.     A semiconductor device in accordance with claim 9 or 10, wherein

phosphorous concentration in said phosphocilicate glass film has phosphorous concentration of less than 8%.

FIG.1(a)

FIG.1(b)

FIG.1(c)

FIG.1(d)

FIG.1(e)

FIG.2(a)

FIG.2(b)

FIG.2(c)

FIG.2(d)

FIG.2(e)

FIG.2(f)